# EUROPEAN PATENT SPECIFICATION

(11) **EP 1 491 255 B1**
(45) Date of publication and mention of the grant of the patent: **09.12.2009**
(21) Application number: 02768224.4
(22) Date of filing: 05.09.2002
(51) Int. Cl.: B01J 19/08, B01J 19/26

(54) **METHOD FOR CARRYING OUT HOMOGENEOUS AND HETEROGENEOUS CHEMICAL REACTIONS USING PLASMA**
VERFAHREN ZUR DURCHFÜHRUNG VON HOMOGENEN UND HETEROGENEN CHEMISCHEN REAKTIONEN UNTER VERWENDUNG VON PLASMA
PROCEDE POUR EFFECTUER DES REACTIONS CHIMIQUES HOMOGENES ET HETEROGENES UTILISANT LE PLASMA

(30) Priority: 12.02.2002 RU 2002103408
(43) Date of publication of application: 29.12.2004
(73) Proprietor: Otkrytoe Aktsionernoe Obschestvo " Tvel", Moscow, 119017 (RU)
(72) Inventor: SHARAFUTDINOV, Ravel Gazizovich, Novosibirsk, 630128 (RU); KARSTEN, Voldemar Martynovich, Novosibirsk, 630058 (RU); POLISAN, Andrei Andreevich, Moscow, 119517 (RU); SEMENOVA, Olga Ivanovna, Novosibirsk, 630128 (RU); TIMOFEEV, Vladimir Borisovich, Moscow, 121609 (RU); KHMEL, Sergei Yakovlevich, Novosibirsk, 630128 (RU)
(74) Representative: Morf, Jan Stefan
(86) International application number: PCT/RU2002/000410
(87) International publication number: WO 2003/068383

(56) References cited:
- WO-A-96/24703
- WO-A1-94/17899
- DE-A1- 19 546 187
- RU-C1- 2 032 765
- RU-C1- 2 100 477
- RU-C1- 2 132 727
- US-A- 4 871 580
- US-A- 4 957 062

## Description

### Field of the Invention

This invention relates to chemistry, in particular to chemical technologies, and may be exploited, e.g., in electronics for applying metal, semiconductor and dielectric films on metal, semiconductor and dielectric substrates, cleaning (etching) surfaces; in the chemical industry for producing extra pure substances, including bulk solid-state materials; in metallurgy for producing extra pure metals.

### Prior Art

It is known that by dissociation, ionization and excitation of molecules being in the gas or vapor phase of substances it is possible to accelerate the course of various chemical reactions. This phenomenon underlies methods of conducting chemical reactions in plasma where practically all substances, even most inert and stable chemically, become highly active due to the dissociation of a significant portion of substance molecules into radicals, the ionization with the formation of ions and electrons as well as the excitation of inner degrees of freedom of atoms, molecules and radicals.

Thus, for example, known in the art is a method of carrying out high-temperature chemical reactions of, at least, two reagents when they are acted on by the plasma arch of an electric discharge. According to this method the plasma arch is formed in the reaction chamber between the anode and the cathode when a high voltage is applied to them. At least one reagent is introduced into the chamber in its liquid state in such a way that at least one vortex is formed, which creates and stabilizes the plasma arch. This reagent evaporates at high temperatures inside the vortex, and another liquid or gaseous reagent or several reagents are introduced into plasma for carrying out a chemical reaction or several chemical reactions. The second and other reagents may be introduced into plasma in the form of the second or a plurality of other vortexes, or, when they are preliminarily mixed with each other, in the form of one common vortex. Various target products are removed from fixed points of the plasma arch (US Patent No. 3658673). According to this method, electrons are in the direct contact with the chemically active reaction medium, which, in combination with high temperatures and an electric discharge, aggressively acts on their surfaces, thus initiating erosion, therefore, electrodes are quickly become useless and require their frequent replacements - within the period of a few hours. In the course of erosion atoms and microscopic particles, which constitute such substances, separate from them and come into the plasma arch, entering into unwanted reactions and forming unwanted compounds, which foul the target product; therefore, it is impossible to obtain extra pure substances with the use of this method. The erosion of the electrodes increases with the increasing current of the electric discharge; therefore, the described method puts limitations on the maximum current, what, in its turn, limits its maximum productivity.

Also known in the art is a method of decomposition of industrial waste in the thermal plasma. A purifying gas, which contains at least 70 % of oxygen, is fed to the reaction chamber where it flows between the electrodes, to which the voltage of 100 - 3,000 V is applied, which results in the current of 50 - 1,000 A flowing between them and in the formation of a plasma jet. Chemical waste come in the liquid state in the plasma jet in such a quantity that the oxygen content of the plasma jet is at least 30 % higher than that stoichiometrically necessary for the full combustion of such waste. Moreover, it is necessary that the purifying gas has the temperature of not less than 1,450 °C for at least 2 milliseconds. Then the gas is quickly cooled down to 300 °C (US Patent No. 5206879). This method, as the method described earlier, requires frequent, within the period of several hours, replacement of the electrodes, since under the action of oxygen, which is a strong oxidant, the high voltage and the heavy current the erosion of the electrodes takes place very quickly. The method, due to the described reasons, puts limitations on the capacity of the plant where it is implemented.

In the above-described methods of carrying out chemical reactions the reaction mixture also is used as the plasma-generating gas. When a chemically active reaction mixture is between the electrodes, to which a high voltage is applied, the electric current of high amperage is going through it, which contributes to its instantaneous heating to the plasma state and maintains a high temperature of the plasma. Due to the contact between the electrodes and the chemically active plasma, quick erosion of the electrodes occurs, and the reaction mixture is fouled. In order to reduce the erosion of the electrodes there exist several known technical solutions where the plasma-generating gas is an inert gas, e.g., nitrogen, argon or hydrogen. The plasma-generating gas is converted into plasma also under the action of an electric discharge in a specially equipped flash chamber, and then it is combined with the reaction mixture in the reaction chamber where chemical reactions go under the activating action of plasma.

For example, known in the art is the method of carrying out high-temperature chemical reactions for the purpose of producing powders of highly pure metals of groups IVb, Vb, VIb of the periodic table: titanium, tungsten, molybdenum, etc., or their alloys, as well as carrying out halogenation of metal oxides, synthesis of hydrocarbons: acetylene, benzene, etc., which is implemented as follows. A plasma arch is generated by an electric discharge in a plasma generator between its cathode and anode in flowing the plasma-generating gas - argon or nitrogen. The generated plasma is continuously fed from the generator to the reaction zone being below the anode, into which a gaseous reaction mixture is simultaneously introduced. In the result, in the plasma flow in the reaction zone a chemical reaction is going on with the formation of the target product. Then the flow of the reacted reaction mixture, which contains the target product, undergoes hardening and is separated into several different flows that afterwards are combined in the collector zone, from which the relatively pure target product is extracted (US Patent No. 3840750).

Also known in the art is the method of thermal cracking of substances, primarily hydrocarbons, with the use of plasma. Plasma is generated in a special flash chamber where the anode and the cathode are arranged coaxially and between them the electric arch is formed, through which the flow of the plasma-generating gas - hydrogen or nitrogen - passes. The flash chamber is connected with the mixing chamber where all the necessary reagents are fed to, which form the initial hydrocarbon reaction mixture of the desired composition. Then the initial reaction mixture, after being heated to several thousands of degrees, is fed directly to the reaction chamber where the target product is formed at a pressure not less than 1 atmosphere. The target product is separated by quickly cooling the reacted reaction mixture with a cool hardening gas in the free space over the reaction chamber. After that the target product is fed to a scrubber for washing the gas (US Patent No. 3622493). These methods enable to prolong the life of the electrons to some extent by hindering the erosion due to eliminating their contact with the chemically active medium. But it is not possible to eliminate the erosion completely, since there are some other reasons for it: high voltage, currents of high amperage, bombardment of the surface with plasma particles, etc. It has been already said that under the conditions of erosion of the electrodes the atoms and particles of the substance the electrodes are made of come to the plasma-generating gas and come with the plasma to the reaction zone, enter into reactions and form unwanted substances.

Consequently, all the described methods of carrying out chemical reactions, in the course of which the electrodes participate in generating plasma, do not enable to obtain highly pure target products. Moreover, the carrying-out of chemical reactions with the use of high-temperature plasma requires high operation costs, which are conditioned by forced stops of the reactor for the purpose of replacing the electrodes, and the high capital costs, which are conditioned by constructions of reactors with separate chambers, the use of complex additional equipment as well as expensive heat-resistant materials.

Also known in the art are plasma-stimulated methods of carrying out chemical reactions on solid surfaces, which include, in particular, processes of film deposition, etching, evaporation and some others that are going on in non-equilibrium plasma of low pressure, at relatively low temperatures of the said surfaces, without the liquid phase.

Such methods include, for example, the method of carrying out chemical reactions on a solid surface for obtaining hard thin-film coatings, wherein a plasma flow from the point of its generation by the discharge method is fed to the treatment chamber where the treated surface is arranged. Simultaneously, a working gas comprising the substance, which is deposited to the surface, is fed to the treatment chamber (US Patent No. 4871580). This method does not enable to obtain highly pure homogenous films, since particles of the material the electrodes are made of come to the plasma. The method is also characterized by a low speed of film deposition, therefore it is not suitable for treatment of large surfaces.

Known is another plasmachemical method of carrying out chemical reactions on a surface, wherein the plasma generated at the atmospheric pressure is fed to the treatment chamber where the treated surface is arranged and to where a working substance, capable of being polymerized, is fed simultaneously, which is deposited and covers the treated surface (US Patent No. 4957062). This method has the same disadvantages as the method described above.

Known is a method of carrying chemical reactions on a surface, wherein plasma is generated without using electrodes - this is the method of depositing films of hydrogenised silicon (RF Patent No. 2100477). According to this method, the silicon-containing working gas is fed from a source of the working gas to the vacuum reaction chamber in the form of supersonic flow directly in which electron-beam plasma is generated. For this, an electron beam, under the action of which silicon radicals to be deposited on the surface of a substrate arranged on the path of the working gas flow are formed in the gas flow, is introduced to the reaction chamber transversely to the working gas flow. According to this method, the focused electron beam is introduced into the working gas flow near the nozzle section, which results in: a) significant losses of power introduced into the gas flow by the electron beam due to the fact that the primary and the secondary electrons leave the area where the electron beam interacts with the working gas flow; b) poor reproducibility of the process of gas activation in the electron-beam plasma due to big gradients of the gas density in the jet in the area where the electron beam is introduced, and due to the uncertainty in the distribution of the electron current density in a cross-section of the electron beam.

This method also does not preclude the possibility that electrons may enter to the volume of the gas source from the zone of interaction between the beam and the working gas, which results in the formation of fine-dyspersated particles that, in their turn, when coming to the substrate surface, worsen its quality. It is also possible that activated particles will enter into the volume of the electron gun from the zone of interaction between the electron beam and the gas flow, which will result in the deposition of films on inner surfaces of the electron gun, shortening its service life and losses of the working substance, i.e., hydrogenised silicon.

### Description of the Invention

This invention has solved the task of creating a method of carrying out homogenous and heterogeneous chemical reactions with the use of plasma, which should ensure the obtaining of highly pure target products, should be characterized by high productivity, low, in comparison with the known methods, capital and operation costs and a high rate of use of initial working substances.

The set task has been solved due to that a method of carrying out chemical reactions is proposed, wherein the reaction gas is fed from a source of reaction gas to a vacuum reaction chamber, a supersonic flow of the reaction gas is formed in the said chamber, and the said flow of the reaction gas is activated by acting on it with an electron beam for generating electron-beam plasma, the said supersonic flow of the reaction gas being formed in such a way that a zone of negative pressure with a lowered, in comparison to that of the adjacent parts, density is formed at the entrance to the vacuum reaction chamber, and the irradiation of the reaction gas with the said electron beam is carried out by introducing the said electron beam into the zone of negative pressure.

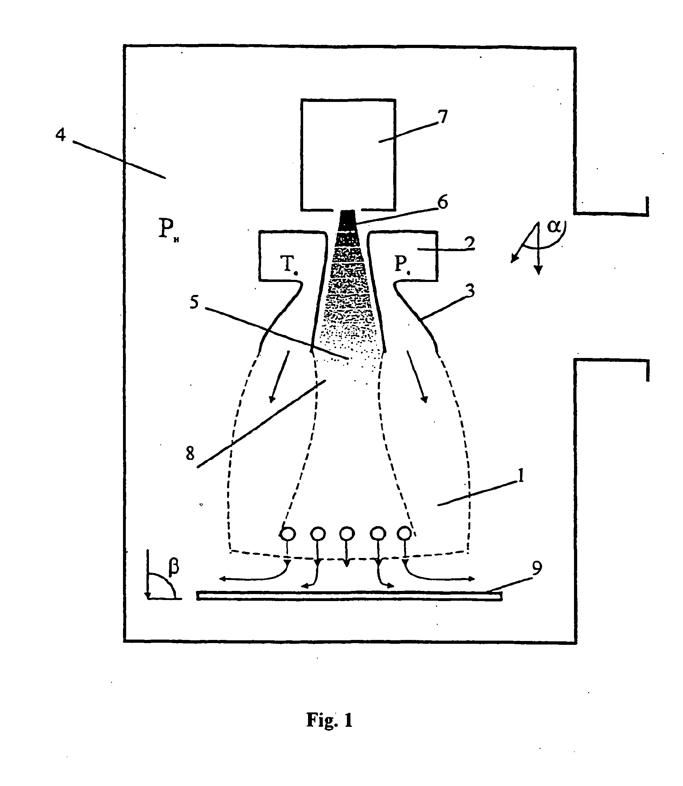

The schematic diagram of carrying out this method is shown in Fig. 1. The supersonic flow (1) of the reaction gas is formed when the said gas is fed from the source (2) of the reaction gas through the inlet nozzle (3) to the vacuum reaction chamber (4). For this purpose the pressure in the source of the reaction gas is maintained at a level at least 10 times higher than that of the pressure in the vacuum reaction chamber, when the absolute pressure in the source of the reaction gas is not less than 5 torr (667 Pa). The said inlet nozzle (3) may be made in a variety of forms, namely, in the form of a round circular opening, in the form of a slit closed along its perimeter, in the form of profiled nozzles, but the use of a profiled annular inlet nozzle, as shown in Fig. 1, is most efficient.

When then reaction gas enters through the inlet nozzle into the vacuum reaction chamber due to a pressure difference between the source of the reaction gas and the vacuum reaction chamber, the formation of a supersonic flow of the reaction gas is ensured in the form of a free, underexpanded supersonic jet of the said gas. At this, the reaction gas containing chemical reagents, e.g., monosilane and the carrier - an inert gas, is fed continuously to the source (2) of the reaction gas from an external source through the gas passing system. The reaction gas passes through the source of the reaction gas and enters through the inlet profiled annular nozzle (3) into the vacuum reaction chamber (4). In the source of the reaction gas, in the result of a balance between the entering volume of the gas and its flow rate, the brake pressure P₀ is established. The pressure P₀ in the source of the reaction gas is maintained at a level at least 10 times higher than that of the pressure P_{H} in the vacuum reaction chamber by pumping the gas out of the reaction chamber by vacuum pumps. Therefore, at the border of the inlet opening of the vacuum reaction chamber a pressure difference is formed, and when the reaction gas comes from its source to the vacuum reaction chamber it expands, and beyond the border of the inlet opening, i.e., the inlet nozzle section, a well-known free, supersonic, underexpanded has jet is formed - the said supersonic flow of the reaction gas. Due to the discharge of the supersonic flow of the reaction gas from the inlet nozzle having the annular form, in the central part of the said flow the zone (5) of negative pressure is formed with a lowered, relative to the adjacent parts, density. As the distance from the inlet nozzle section increases, that is, when the flow of the reaction gas expands in the vacuum reaction chamber, its density decreases, and the reaction gas gets cooler, and the speed of the directed movement of molecules in the jet achieves the limit values. Since the reaction gas expands when it enters into the vacuum reaction chamber under a final pressure, which is not equal to zero, its molecules collide with molecules of the background gas of the said chamber. These collisions result in the formation of a typical wave structure - a side shock wave and the Mach disc. The reaction gas mixes with the background gas along the border of the flow of the reaction gas. The dimensions of the wave structure depend on the geometry of the inlet opening, or the nozzle, its dimensions, and the relation between the pressure P₀ in the source of the reaction gas and the pressure P_{H} in the vacuum reaction chamber. The greater is the value of this relation, the bigger are the dimensions of the supersonic jet, i.e., the said flow of the reaction gas.

The dissociation/activation of molecules of chemical substances, as contained in the reaction gas, which is necessary for initiating chemical reactions, takes place in electron-beam plasma. In order to generate it, the electron beam (6), which is formed in the electron gun (7), is introduced into the vacuum reaction chamber, the said electron beam being introduced into the flow of the reaction gas at a randomly selected angle α to the axis of the said flow; however, the introduction of the electron beam along the axis of the reaction gas flow, as shown in Fig. 1, is the most efficient. And the energy of the beam primary electrons is selected in such a quantity that all the primary electrons would degrade and pass their energy to the flow of the reaction gas. A change in the energy of the electron beam is carried out by changing the applied accelerating potential of the electron gun from an external source. The quantity of the necessary energy of the electron beam is determined both by the flow rate of the reaction gas and by its composition. The amperage of the electron beam is regulated by an external source and determines, at a selected energy of the electron beam, the amount of power introduced into the flow of the reaction gas. The number of activated particles (radicals, ions, excited particles) present in the flow of the reaction gas depends on that amount of power. In the result of the interaction between the primary electrons of the electron beam and molecules of the reaction gas the latter's molecules are activated and the secondary electrons are generated. Some of the said secondary electrons, which have the energy exceeding the ionization threshold, generate secondary electrons of next generations, which, in their turn, generate secondary electrons of the following generations, etc. The energy of the primary and the secondary electrons, as well as the energy of the formed ions and the excited particles of the reaction gas, is spent on the dissociation of its molecules into radicals, the excitation of the inner degrees of freedom (electron, oscillatory and rotational ones) and the direct heating of the reaction gas. Thus, in the vacuum reaction chamber, in the area of interaction between the electron beam and the reaction gas the chemically active, electron-beam plasma (8) is generated. The share of energy, which is delivered by the primary electrons, depends on the accelerating potential of the electron gun, the dimensions of the reaction gas flow, the level and the distribution of the density of the gas molecules, on which the dissipation of the primary electrons takes place.

The function of electron energy distribution (FEED), being the most important characteristic of plasma, enables to calculate the speed of some or another process. The portion of electrons with a set energy for the electron-beam plasma may be decreased or increased by any amount, depending on the current of the electron beam, whereas in the discharge plasma a change in the current strength results in a change in FEED, and FEED itself is limited by temperature at the level of several eV. In the range of energies less than 10 eV the Maxwell electron energy distribution occurs, FEEDs in the electron-beam plasma and the discharge plasma are close to each other in respect of their forms, while in the range of energies more than 10 eV the electron-beam plasma contains much more secondary electrons. The speed of generating particles in the processes of ionization, dissociation, excitation, etc is determined by the relation *nₑvₑn*□*ⱼ*, where nₑ is the number of electrons of the set energy; vₑ is their density; n is the density of the peculiar gas component in the mixture (e.g., SiH₄); □ⱼ is the section of the corresponding process (ionization, dissociation, excitation, etc.). Therefore, FEED determines speeds of processes going in plasma. For example, the speed of deposition of a-Si:H films in the discharge plasma is determined by the flow of SiH₃ radicals coming on the surface of a substrate. The speed of generating SiH₃ radicals, in its turn, is proportional to the above-indicated product. In the electron-beam plasma the speed of dissociation is significantly higher than in the discharge plasma at the other equal conditions, since it contains a significantly greater number of electrons with the energy higher than the threshold of the said process. In plasma, both the discharge one and the electron-beam one, there are much more electrons with the energy lower than the threshold of dissociation. Those electrons do not participate in dissociation. In order the said electrons may participate in dissociation, it is necessary to apply an external electric field for the purpose of shifting FEED to the range of higher energies, which may be done in the electron-beam plasma, contrary to the discharge plasma.

An important property of the electron-beam plasma is that the main contribution to the speed of dissociation is determined not by the primary electrons (their contribution << 1 %), but the secondary ones. This fact puts certain requirements to the geometry of the introduction of an electron beam into the reaction gas flow in order the secondary electrons may not leave the reaction gas flow before the time when they deliver their energy for the gas dissociation. Therefore, it is advisable to introduce an electron beam to the vacuum reaction chamber in such a way that it would come along the axis of the flow directly to the vacuum portion of the reaction gas flow - the zone (5) of negative pressure, which has a lower density compared to that of the adjacent portions of the flow. Electron guns of various types may be used as a source of the electron beam, namely, hot-cathode guns, gas discharge guns, plasma guns, etc., including also electron guns with the hollow cathode.

The interaction between the neutral flow of the reaction gas and the said electron-beam plasma insignificantly changes the movement trajectory of the flow molecules, therefore, the reaction gas particles, which are activated in the plasma, continue moving in the same directory as the non-activated molecules. The chemical reagents, which are in the electron-beam plasma in the form of ions and radicals, enter into chemical reactions in the gaseous phase with the obtaining of the target product. The removal of the target product for homogenous reactions, as are carried out in the gaseous phase, may be carried out by any known methods, e.g., by condensation. If the composition of the reaction gas comprises molecules of a substance suitable for film deposition (for example, molecules of monosilane, SiH₄) and on the way of the activated flow of the reaction gas in the reaction chamber a substrate (9) made of a corresponding material, e.g., steel, is arranged at the angle □ to the axis of the flow (nozzle), then a heterogeneous chemical reaction is going on the substrate surface with the formation of a film of the target product, e.g., silicon.

The convective transfer of activated substances in the supersonic jet of the reaction gas flow, in contract to the diffusion transfer, which is carried out in reactors with the activation of the reaction gas in a gas discharge, ensures:
- a shortening of the time, for which the active particles of the reaction gas are in the reaction chamber, which reduces the number of undesirable collisions of these particles between themselves. For example, the time, during which a particle activated by an electronic shock reaches the substrate, onto which a substance is deposited, is 100 times less than that in the variant with the diffusion transfer; and that significantly diminishes the possibility of forming fine-dyspersated particles, which lead to defects in obtained substances or in the deposited film;
- independence of the reaction gas parameters from the conditions existing in the vacuum reaction chamber, and the known relationship between the reaction gas parameters in the reaction chamber and the source of the reaction gas, which determined reproducibility and predictability of the process of obtaining target products or growth of films.

The electron-beam activation of the reaction gas molecules ensures:
- the possibility of independently changing the energy and the power of the activation source; ,
- higher speeds of activation (in particular, dissociation) of molecules in comparison to those in the discharge plasma due to the presence of high-energy secondary electrons in the electron-beam plasma;
- the possibility of further accelerating the activation process by applying an electromagnetic field to the electron-beam plasma for accelerating the slow secondary electrons and their and holding in the volume of the plasma.

The described method of carrying out chemical reactions has a number of advantages, the principal of which are:
- a high speed of chemical reactions, which is conditioned by the ultraspeed and compact feeding of the power from the electron beam to the reaction mixture where radicals and excited particles are formed with a high speed;
- low power inputs, which are conditioned both by a greater, compared to the known methods, number of electrons in the electron-beam plasma, which are capable of dissociating molecules, and a high speed of chemical reactions, which results in a minimum heat exchange with the external environment;
- the absolute purity of the process, which is conditioned by that the reactor where it is realized does not have heated parts, and radicals are formed inside the gas jet preventing molecules of the background gas from coming from the vacuum reaction chamber.

When carrying out heterogeneous chemical reactions, primarily for applying films of a uniform thickness to hard surfaces of substrates, the method may be modified in accordance with the embodiments described below.

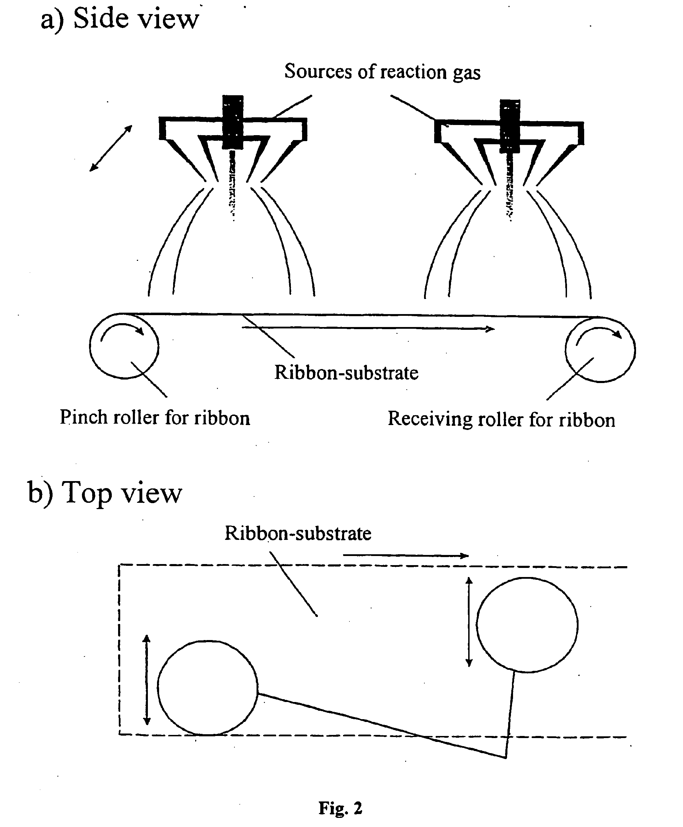

The simplest embodiment is shown in Fig. 2. The axes of the jets from one or more sources of the reaction gas are directed transversely to the plane of the substrate made in the form of a ribbon. The substrate-ribbon is moved from the pinch roller to the receiving roller. One or more sources of the reaction gas are moved transversely to the ribbon within the limits of the reaction gas flow. Through movement of the ribbon and the sources the deposition of films with a uniform thickness onto the substrate surface is achieved. For the purpose of achieving the same result the reciprocal motion of the ribbon moving mechanism is possible while the sources of the reaction gas are stationary. The number of sources of the reaction gas, their intensity (sum, as to the area, speed of deposition) may be determined proceeding from the desired thickness of the film, the width of the ribbon and the general capacity of the plant.

As has already been said, in Fig. 2 the positional relationship of the reaction gas sources and the substrate as well as the directions of their movement are orthogonal. But their positional relationship at arbitrary angles is also possible. For example, in order to achieve a greater uniformity of the film thickness, non-orthogonal arrangements and movements of the plant elements are possible.

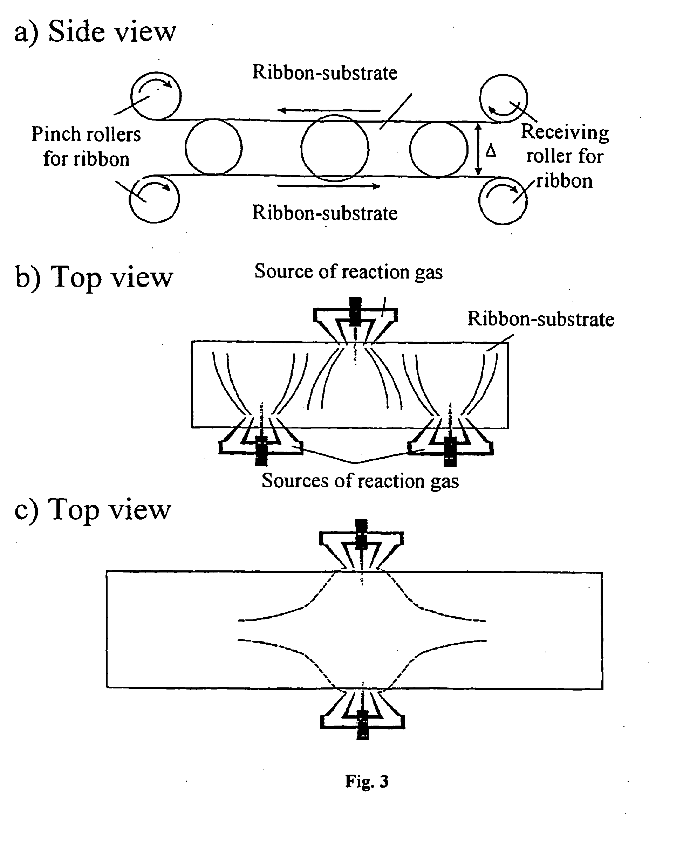

Another variant of the positional relationship of the reaction gas sources and the treated substrates is shown in Fig. 3 (a - c), where the reaction gas flow comes into the gap between the two ribbons-substrates. This method of feeding activated particles onto the substrate ensures a greater, than in the embodiment shown in Fig. 2, use factor of the reaction gas, since the deposition is carried out onto two substrates, and, moreover, by choosing the gap size between the substrates it is possible to deposit a greater portion of the particles activated in the reaction gas flow. The uniformity of the film thickness is achieved by mechanically moving either one ribbon, or both of them. In this variant it is also possible to additionally mechanically move the reaction gas sources. Thus, for example, in Fig. 3 © the reaction gas sources are arranged opposite to each other. The interaction of jets of the reaction gas flows in the gap between the two ribbons-substrates results in turning the flows in the direction parallel to the ribbon. And the position of the zone where the jets interact depends on the intensities of the reaction gas sources. By changing the intensities of the reaction gas sources it is possible to change the location of the zone where the jets interact, thus, without moving the said sources it is possible to obtain a film of uniform thickness at the maximum use factor of the reaction gas.

In the examples of modifying the method, as cited above, the surface of the treated substrate has a flat form, but the method is suitable also for other forms of substrates, for example, in the form of a cylinder, with the deposition of films both onto the inner surface and onto the outer surface.

Some other modifications of the described method of carrying out chemical reactions are also possible.

### Brief Description of the Drawings

Fig. 1 shows the schematic diagram of carrying out the method, where: 1 - the supersonic flow of the reaction gas; 2 - the source of the reaction gas; 3 - the inlet nozzle; 4 - the vacuum reaction chamber; 5 - the zone of negative pressure; 6 - the electron beam; 7 - the electron gun; 8 - the electron-beam plasma; 9 - the substrate.
Fig. 2 shows an embodiment for obtaining uniform films on substrates, when the reaction gas sources are moved mechanically.
Fig. 3 shows an embodiment for obtaining uniform films on substrates, when the substrates are moved mechanically and the reaction gas flows are controlled by gas dynamics methods.

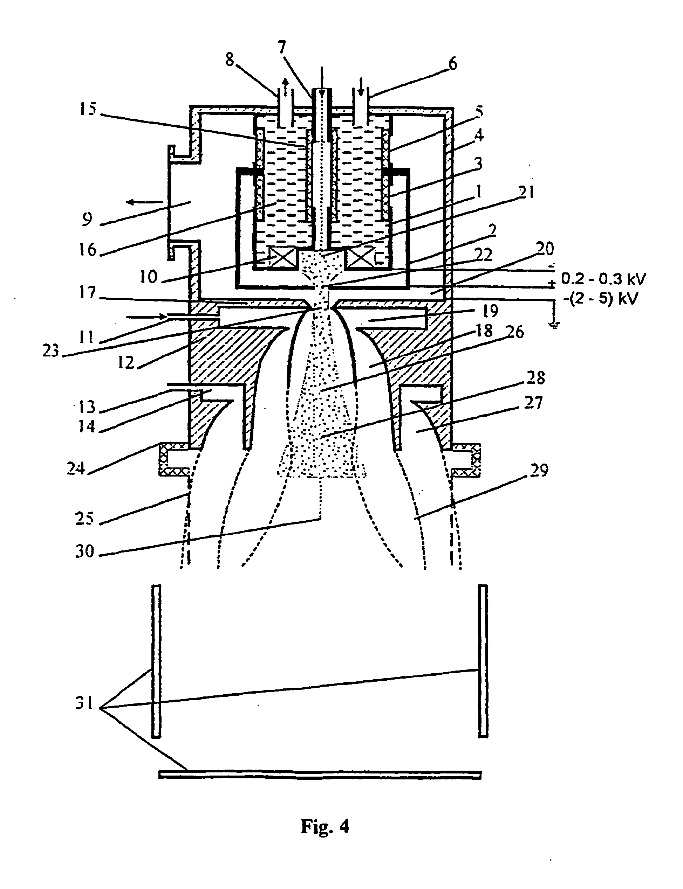

Fig. 4 shows the layout of a plant with the annular source of the reaction gas, which is combined with an electron gun, where: 1 - the cathode of the electron gun; 2 - the anode of the electron gun; 3 - an insulator; 4 - the housing of the electron gun and the source of the reaction gas; 5 - an insulator; 6 - the tube for supplying a coolant to the electron gun; 7 - the tube for supplying gaseous helium to the area of the hollow cathode of the electron gun; 8 - the tube for draining the coolant from the electron gun; 9 - the fitting for vacuum pumping-out from the volume of the electron gun; 10 - the permanent annular magnets; 11 - the tube for supplying the protective gas (helium, hydrogen) into the inner annular nozzle; 12 - the housing of the annular sources of the protective gas and the reaction gas; 13 - the tube for supplying the reaction gas; 14 - the annular prechamber - a source of the reaction gas; 15 - an insulator; 16 - the coolant of the electron gun; 17 - the extractor of the electron gun; 18 - the inlet annular nozzle for the protective gas; 19 - the annular prechamber - a source of the reaction gas; 20 - the pumped out volume of the electron gun; 21 - the hollow cathode; 22 - the opening in the cathode; 23 - the opening in the extractor; 24 - the fixture of the grid; 25 the grid for supplying the potential; 26 - the electron beam; 27 - the inlet annular nozzle for the reaction gas; 28 - the zone of negative pressure; 29 - the supersonic flow of the reaction gas; 30 - the axis of the reaction gas flow and the electron beam; 31 - the substrate.

### Preferred Embodiment of the Invention

### Example 1.

For applying a silicon film to the surface of a substrate made of stainless steel the reaction gas is used, which contains monosilane SiH₄ and argon Ar as the carrier. The plant for applying the film on the substrate is made in accordance with the diagram shown in Fig. 1. It comprises the reaction vacuum chamber (4), the annular source (2) of the reaction gas, which is combined with the electron gun (7). The plant comprising the annular reaction gas source combined with the electron gun is shown in Fig. 4.

By continuous pumping out the gas from the volume of the vacuum reaction chamber the pressure of 10⁻² torr is maintained in it. Helium is fed with the flow rate of 50 cm³/min from an external supply system to the volume of the plasma electron gun with the hollow cathode. The electric potential of 0.2 - 0.3 keV is applied between the cathode (1) and the anode (2) from an external source of discharge. In the result, a glow discharge appears in the hollow cathode (21). The permanent annular magnets (10) serve for increasing the electron density in the axial portion of the hollow cathode. A gas discharge in the hollow cathode serves as the emitter of electrons. The draw and acceleration of electrons from the discharge is carried out by applying the negative potential of 2 - 5 keV between the insulated electric electrode (2) and the extractor (17) that is the grounded housing (4) of the reaction gas source. The accelerated electrons through the openings (22) and (23) are entering into the reaction gas flow of annular form through the paraxial zone (28) of negative pressure in the said flow. The reaction gas is fed through the tube (13) to the annular prechamber (14) that is the source of the reaction gas, and the external annular nozzle (27) with the flow rate of 12 L/min. In order to prevent silicon radicals from entering into the volume of the electron gun, helium from the external source is fed with the flow rate of 2 L/min to the internal annular nozzle (18) through the tube (11) and the annular prechamber (19) that is the source of the protective gas. For the purpose of additionally accelerating the secondary electrons the positive potential of 60 V is applied to the annular grid (25). The reaction gas is fed to the reaction chamber through the inlet nozzle (27) made in the form of the Laval nozzle of the annular form, the reaction gas being fed at a pressure for its entering into the vacuum reaction chamber with forming a supersonic gas flow, in the inner portion of which, at the inlet of the chamber, the zone (28) of negative pressure is formed where the flow density is lower than the density of the adjacent zones. The electron beam (26) formed by the electron gun is introduced into this zone of negative pressure along the axis of the nozzle. In the result of the interaction between the electron beam and the reaction gas in the reaction gas flow the electron-beam plasma is generated, the molecules of monosilane SiH₄ are dissociated and activated and the internal degrees of freedom of molecules, atoms and radicals of the reaction gas are excited. The silicon-containing radicals SiHₓ, as generated in the electron beam plasma, together with the flow of neutral, non-activated molecules, move towards the substrate (31) arranged according to the direction of movement of the reaction gas, behind the activation zone, as shown in Fig. 1, or in parallel with the axis of the nozzle. The absorption of the activated particles and various heterogeneous reactions take place on the surface, in the result of which a silicon film is formed on the treated surface. The substrate temperature is regulated with the heater, and the temperature is controlled with a thermocouple. The structure of the obtained silicon layers is determined by the material and the temperature of the substrate. Thus, when the substrate temperature is 250 °C, a film of amorphous silicon is formed on it. When the temperature is 250 °C, a film of nanocrystalline silicon, i.e., silicon with crystalline inclusions of nanometric size, is formed on the substrate distant from the plasma generation zone. When the substrate temperature is 640 °C, on non-orientable substrates (stainless steel, ceramics) a film of microcrystalline silicon is formed with the size of crystals more than 100 nm, whereas the speed of growth achieves 20 nm/s. When a monocrystalline silicon substrate is substituted for a substrate at the substrate temperature of 640 °C, homoepitaxy, i.e., growth of monocrystalline silicon, takes place, resulting in obtaining an epitaxial silicon film with the thickness of 10 microns at the speed of 12 nm/s.

### Example 2.

The hydrogenation of silicon tetrachloride SiCl₄ to trichlorosilane is carried out. For this the plant is used, which is shown in Fig. 4 and described in detail in Example 1, with a quartz tube of cylindrical section, which is installed instead of the substrate (31). The axis of cylinder coincides with the axis of the reaction gas flow. A mixture of silicon tetrachloride and hydrogen in the molar relation 1 : 4 (silicon tetrachloride to hydrogen) is introduced in the annular source through the tube (13) to the prechamber (14) as the reaction gas. The reaction gas is supplied from a special evaporator. The electron beam with the accelerating potential of 2 keV is introduced into the reaction gas flow in the zone of negative pressure. At the exit from the vacuum reaction chamber a sampling device is arranged, in which a sample of the reaction gas, as treated in the plasma, is collected. As the sampling device a cryogenic trap is used, which is cooled down to the liquid nitrogen temperature and in which the reaction gas is condensed. The composition of the reaction gas in a sample is analyzed with the use of a mass-spectrometer. By analyzing samples the molar relation is determined, which, for example, at the specific introduced power of 2 kJ/g (2 kW/g·s) is 0.2 - 0.36. At the same time the said relation, according to thermodynamic calculations, at the said conditions is 0.18 - 0.4. It means that the experimental data is very close to the equilibrium thermodynamic calculations and confirms that in the proposed method the transition from the equilibrium state of the source reaction gas to the final equilibrium state occurs very rapidly, practically without heat exchange with the external environment. The comparison of the described method with analogous solutions for carrying out the plasmachemical hydrogenation of silicon tetrachloride to trichlorosilane as to the power inputs shows that the power inputs are 4 times less as a minimum at the same level of hydrogenation.

The target product - trichlorosilane SiHCl₃ - is extracted by condensation in the condensation chamber, to which the reaction gas comes from the vacuum reaction chamber.

### Example 3

Pure polycrystalline silicon is to be obtained. The process is carried out at the same conditions, as in Example 1, in the plant, which is shown in Fig. 4. The substrate of cylindrical form, which is made of metal foil, is placed in a heated cylindrical quartz tube, the axis of which coincides with the axis of the reaction gas flow containing SiH₄ and He. The substrate has a cylindrical form in order as many as possible silicon particles activated in the plasma may be deposited on it - ultimately, all such particles. By the weight of the silicon, which is deposited on the substrate surface, the specific power inputs and the coefficient of transformation of gaseous monosilane into polycrystalline silicon on the substrate surface are determined. At the electron beam accelerating potential of 2 keV, the beam current of 0.3 A, the reaction gas flow rate of 12 L/min and the substrate temperature of 750 °C the specific power inputs are 200 kJ per 1 g of silicon, and the use factor of monosilane is 45 %. For 10 minutes of the plant operation on the said substrate a layer of silicon with the thickness of 32 microns has been obtained, which is detached from the substrate after its cooling. On the substrate materials with the linear expansion temperature coefficient equal to the coefficient stated for silicon the obtained silicon layers may not be detached. For obtaining thicker silicon layers several identical jet sources are used and the layers are applied on the moving continuous substrate. The obtained layers are detached by rapid cooling of the substrate ribbon at the exit from the reaction chamber. The detachable pure silicon is removed from the substrate ribbon.

### Industrial Applicability

This method may be utilized in the chemical industry and industries connected with it for the purpose of producing chemically pure substances; in large-area electronics and in optics for applying on them solid-state films and modifying surfaces by etching; in the powder metallurgy for producing powders of pure metals; for producing ceramic powders, in particular oxides, nitrides, carbides of metals and semiconductors. The described method, owing to its universality, may be a basic method for various technologies: those used for cleaning substrates, creating alloyed and non-alloyed layers, production of thin-film solar cells or other thin-film devices on large areas of substrates. For carrying out the method the plant, which is shown in Fig. 4, may, for example, be used.

## Claims

1. A method of carrying out chemical reactions, comprising feeding the reaction gas from the reaction gas source to the vacuum reaction chamber, forming a supersonic flow of the reaction gas in it, and activating the said supersonic flow of the reaction gas by acting on it with an electron beam for generating electron-beam plasma, **characterized in that** the said supersonic flow of the reaction gas is formed in such a way that a zone of negative pressure is created in its central portion at the entry into the vacuum reaction chamber, said zone having a density lower than those of the zones adjacent thereto, and the action on the supersonic flow of the reaction gas is carried out with the electron beam by introducing the said electron beam into the said zone of negative pressure.

2. The method according to Claim 1, **characterized in that** the supersonic flow of the reaction gas is formed by maintaining a pressure in the reaction gas source at a level that is at least 10 times higher than the pressure in the vacuum reaction chamber.

3. The method according to Claim 2, **characterized in that** the absolute pressure in the reaction gas source is maintained at a level of not less than 5 torr (667 Pa).

4. The method according to Claim 1, **characterized in that** the supersonic flow of the reaction gas at the entry into the vacuum reaction chamber has, in a section transverse to its axis, a ring-shaped, primarily annular, form.

5. The method according to Claim 1, **characterized in that** the supersonic flow of the reaction gas is acted on by an electron beam being directed along the axis of the said supersonic flow of the reaction gas.

## Patentansprüche

1. Ein Verfahren zur Durchführung chemischer Reaktionen, umfassend das Einspeisen des Reaktionsgases aus der Reaktionsgasquelle in die Vakuumreaktionskammer, das Erzeugen einer Überschallströmung des Reaktionsgases darin und das Aktivieren der Überschallströmung des Reaktionsgases durch Einwirkenlassen eines Elektronenstrahls darauf zur Erzeugung von Elektronenstrahlplasma, **dadurch gekennzeichnet, dass** die Überschallströmung des Reaktionsgases in einer derartigen Weise gebildet wird, dass ein Bereich mit Unterdruck in dessen Mittelteil am Eingang in die Vakuumreaktionskammer erzeugt wird, wobei dieser Bereich eine niedrigere Dichte besitzt als diejenigen der daran angrenzenden Bereiche, und dass die Einwirkung auf die Überschallströmung des Reaktionsgases mit dem Elektronenstrahl durch Einbringen des Elektronenstrahls in den Bereich mit Unterdruck erfolgt.

2. Das Verfahren gemäß Anspruch 1, **dadurch gekennzeichnet, dass** die Überschallströmung des Reaktionsgases durch Halten eines Drucks in der Reaktionsgasquelle auf einem Niveau, das wenigstens 10 Mal höher ist als der Druck in der Vakuumreaktionskammer, gebildet wird.

3. Das Verfahren gemäß Anspruch 2, **dadurch gekennzeichnet, dass** der Absolutdruck in der Reaktionsgasquelle bei einem Niveau von nicht weniger als 5 Torr (667 Pa) gehalten wird.

4. Das Verfahren gemäß Anspruch 1, **dadurch gekennzeichnet, dass** die Überschallströmung des Reaktionsgases am Eingang in die Vakuumreaktionskammer in einem Bereich quer zu ihrer Achse, eine ringförmige, hauptsächlich ringartige Gestalt besitzt.

5. Das Verfahren gemäß Anspruch 1, **dadurch gekennzeichnet, dass** auf die Überschallströmung des Reaktionsgases ein Elektronstrahl einwirkt, der entlang der Achse der Überschallströmung des Reaktionsgases gelenkt wird.

## Revendications

1. Procédé d'exécution de réactions chimiques, comprenant l'alimentation du gaz de réaction provenant de la source de gaz de réaction dans la chambre de réaction à vide, formant un flux supersonique du gaz de réaction dans celle-ci, et l'activation dudit flux supersonique du gaz de réaction en agissant sur celui-ci au moyen d'un faisceau d'électrons pour générer un plasma de faisceau d'électrons, **caractérisé en ce que** ledit flux supersonique du gaz de réaction est formé de telle sorte qu'une zone de pression négative soit créée dans sa partie centrale à l'entrée dans la chambre de réaction à vide, ladite zone ayant une densité inférieure à celles des zones qui lui sont adjacentes, et l'action sur le flux supersonique du gaz de réaction s'effectue avec le faisceau d'électrons en introduisant ledit faisceau d'électrons dans ladite zone de pression négative.

2. Procédé selon la revendication 1, **caractérisé en ce que** le flux supersonique du gaz de réaction est formé en maintenant une pression dans la source de gaz de réaction à un niveau qui est au moins 10 fois supérieur à la pression dans la chambre de réaction à vide.

3. Procédé selon la revendication 1, **caractérisé en ce que** la pression absolue dans la source de gaz de réaction est maintenue à un niveau non inférieur à 5 torrs (667 Pa).

4. Procédé selon la revendication 1, **caractérisé en ce que** le flux supersonique du gaz de réaction à l'entrée dans la chambre de réaction à vide a, dans une section transversale à son axe, une forme en forme de bague, essentiellement annulaire.

5. Procédé selon la revendication 1, **caractérisé en ce que** le flux supersonique du gaz de réaction subit l'action d'un faisceau d'électrons qui est dirigé le long de l'axe dudit flux supersonique du gaz de réaction.
